(19) Europäisches Patentamt
European Patent Office
Office européen des brevets

(11) **EP 3 137 881 B1**

(12) **FASCICULE DE BREVET EUROPEEN**

(45) Date de publication et mention
de la délivrance du brevet:
**15.08.2018 Bulletin 2018/33**

(51) Int Cl.:
*G01N 21/67* (2006.01)          *B23K 26/36* (2014.01)
*G01J 3/443* (2006.01)          *G01B 11/22* (2006.01)
*G01N 21/68* (2006.01)          *H01J 37/32* (2006.01)

(21) Numéro de dépôt: **15725819.5**

(22) Date de dépôt: **28.04.2015**

(86) Numéro de dépôt international:
**PCT/FR2015/051156**

(87) Numéro de publication internationale:
**WO 2015/166186 (05.11.2015 Gazette 2015/44)**

(54) **SYSTEME ET PROCEDE DE SPECTROMETRIE DE DECHARGE LUMINESCENTE ET DE MESURE IN SITU DE LA PROFONDEUR DE GRAVURE D'UN ECHANTILLON**

VERFAHREN ZUR GLIMMENTLADUNGSSPEKTROSKOPIE UND SYSTEM ZUR IN-SITU-MESSUNG DER ÄTZTIEFE EINER PROBE

GLOW DISCHARGE SPECTROSCOPY METHOD AND SYSTEM FOR MEASURING IN SITU THE ETCH DEPTH OF A SAMPLE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **30.04.2014 FR 1453997**

(43) Date de publication de la demande:
**08.03.2017 Bulletin 2017/10**

(73) Titulaire: **Horiba France SAS**
**91160 Longjumeau (FR)**

(72) Inventeurs:
• **RICHARD, Simon**
**91120 Palaiseau (FR)**
• **GASTON, Jean-Paul**
**91810 Vert le Grand (FR)**
• **ACHER, Olivier**
**91190 Gif-sur-Yvette (FR)**
• **CHAPON, Patrick**
**91140 Villebon-sur-Yvette (FR)**

(74) Mandataire: **Jacobacci Coralis Harle**
**32, rue de l'Arcade**
**75008 Paris (FR)**

(56) Documents cités:
**WO-A1-2012/077652          FR-A1- 2 843 801**
**JP-A- 2002 048 519          JP-A- 2002 129 364**
**US-A1- 2005 287 815          US-A1- 2013 314 692**

• **AMARY P ET AL: "A new sensor for trench depth monitoring: the TDM 200", PROCEEDINGS OF SPIE, S P I E - INTERNATIONAL SOCIETY FOR OPTICAL ENGINEERING, US, vol. 5343, no. 1, 1 janvier 2003 (2003-01-01), pages 244-254, XP002356930, ISSN: 0277-786X, DOI: 10.1117/12.529023**
• **"ETCH RATE MONITOR", IBM TECHNICAL DISCLOSURE BULLETIN, INTERNATIONAL BUSINESS MACHINES CORP. (THORNWOOD), US, vol. 29, no. 5, 1 octobre 1986 (1986-10-01), page 2204, XP000806288, ISSN: 0018-8689**

**Description**

**Domaine technique auquel se rapporte l'invention**

La présente invention se rapporte aux appareils et procédés d'analyse élémentaire à décharge luminescente (GD ou Glow Discharge en anglais), par spectrométrie d'émission optique (GD-OES) ou par spectrométrie de masse (GD-MS).

Plus précisément, l'invention concerne un appareil et un procédé de spectrométrie de décharge luminescente (GDS pour Glow Discharge Spectrometry) adapté pour mesurer *in situ* la profondeur de gravure d'un échantillon exposé à ce plasma de décharge luminescente.

L'invention s'applique en particulier à un système ou un procédé d'analyse de matériaux par spectrométrie de décharge luminescente, cette analyse étant résolue en fonction de la profondeur de gravure dans l'échantillon.

**Arrière-plan technologique**

La spectrométrie de décharge luminescente est une technique d'analyse qui permet d'analyser la composition chimique élémentaire et/ou moléculaire d'échantillons solides homogènes ou multicouches. La mesure peut se faire au coeur d'un échantillon ou être résolue en profondeur.

La spectrométrie de décharge luminescente est couramment utilisée pour analyser la composition ou le profil de composition d'échantillons solides.

Le principe de la spectrométrie de décharge luminescente consiste à exposer une zone limitée d'une face d'un échantillon à un plasma de gravure. Le plasma arrache des atomes à la surface de l'échantillon, et les place dans des états électroniques ionisés ou excités. La nature de ces atomes est déterminée par l'analyse de leur spectre d'émission dans le plasma, ou du spectre de masse des ions produits dans le plasma. Comme les atomes sont arrachés, un cratère se creuse à la surface de l'échantillon en fonction du temps d'exposition au plasma. Une analyse des signaux détectés par spectrométrie en fonction du temps d'érosion, permet ainsi d'obtenir la composition de l'échantillon résolue en fonction du temps de gravure.

Cependant, la vitesse de gravure varie généralement au cours du procédé de gravure. La vitesse de gravure varie notamment en fonction de la composition de la zone de l'échantillon exposée au plasma et aussi en fonction de phénomènes transitoires liés au démarrage du plasma.

Or, il est souhaitable d'analyser la composition en fonction de la profondeur du cratère d'érosion généré par le plasma, et pas seulement en fonction du temps pendant le plasma d'érosion.

Il existe différentes méthodes pour déterminer la profondeur du cratère d'érosion en fonction du temps.

La méthode la plus utilisée actuellement est basée sur une calibration de la vitesse d'érosion pour des échantillons de référence de composition connue. Cette calibration nécessite de réaliser différentes mesures sur différents échantillons de référence et suppose des hypothèses telles que par exemple une densité connue et/ou homogène. La précision du résultat obtenu reste incertaine.

D'autres méthodes d'analyse par spectrométrie de décharge luminescente et de détermination simultanée de la profondeur de gravure ont été proposées.

Le document de brevet WO 2007/113072_A1 décrit une méthode de détermination d'une variation de hauteur due à l'érosion de la surface d'un échantillon exposée à un plasma de gravure dans un appareil de GDS. La méthode décrite repose sur l'utilisation d'un capteur de déplacement confocal chromatique, qui détecte une variation de position du plan de la surface de l'échantillon par rapport à sa position initiale avant le démarrage du plasma.

Le document de brevet CN102829732 décrit un autre dispositif pour répondre au même problème technique, basé sur un capteur à triangulation. Dans ce cas, le capteur mesure la position d'un faisceau laser réfléchi par la surface dont on souhaite connaitre la profondeur.

D'autre part, le document de brevet US6784989 ou FR 2843801 d'HORIBA Jobin Yvon décrit l'utilisation d'un interféromètre laser à deux ondes. Selon ce document, un faisceau optique est divisé en deux faisceaux secondaires, l'un des faisceaux secondaires étant réfléchi sur la surface de l'échantillon exposée au plasma de gravure, et l'autre faisceau secondaire étant réfléchi sur une surface de référence fixe, externe à l'échantillon. La recombinaison optique des deux faisceaux réfléchis forme un faisceau interférométrique, qui varie en fonction de la profondeur de gravure dans l'échantillon.

Cependant, toutes ces méthodes optiques de mesure sont sensibles à l'échauffement induit par le plasma de gravure qui produit une dilatation de la chambre de décharge luminescente. Un biais peut donc être introduit, puisque l'on ne peut pas différencier l'érosion du cratère et la dilatation de la chambre plasma. Ces méthodes en détermination de la profondeur d'érosion ont donc une précision limitée et ne permettent pas en pratique d'atteindre un niveau de précision inférieur au micron.

De plus les dispositifs optiques à triangulation nécessitent en général une fenêtre optique à faces planes et parallèles, parfois de grande dimension, pour laisser passer les faisceaux optiques. Cependant, un appareil de décharge luminescente par spectrométrie d'émission optique (GD-OES) comporte généralement une chambre plasma disposant d'une ouverture axiale de dimension limitée et fermée de manière étanche par une lentille destinée à collecter le flux d'émission optique et non par une fenêtre plane.

Le remplacement de la lentille de collection du flux d'émission optique par une fenêtre plane, impliquerait une réduction significative du signal d'émission optique collecté, et donc une perte de précision des mesures de spectrométrie d'émission.

Il existe donc un besoin pour un système et un procédé de mesure de la profondeur de gravure d'un échantillon dans un appareil de spectrométrie de décharge luminescente, qui soit précis et qui n'affecte pas les signaux de spectrométrie de décharge luminescente.

**Objet de l'invention**

La présente invention a pour but de remédier aux inconvénients des systèmes antérieurs et propose plus précisément un système de spectrométrie de décharge luminescente et de mesure *in situ* de la profondeur de gravure d'un échantillon comprenant une lampe à décharge luminescente adaptée pour recevoir un échantillon solide et former un plasma de gravure par décharge luminescente, l'échantillon ayant, sur une même face, une première zone exposée au plasma de gravure et une deuxième zone protégée vis-à-vis du plasma de gravure ; un spectromètre couplé à la lampe à décharge luminescente, le spectromètre étant adapté pour mesurer, en fonction du temps d'exposition de la première zone audit plasma, au moins un signal représentatif du plasma de décharge luminescente par spectrométrie d'émission optique et/ou par spectrométrie de masse dudit plasma de décharge luminescente, et un système de mesure *in situ* de la profondeur du cratère d'érosion généré par gravure de la première zone de l'échantillon en fonction du temps d'exposition audit plasma.

Selon l'invention, la mesure de profondeur de gravure prend comme référence de profondeur nulle, à chaque instant, la seconde zone de l'échantillon non exposée au plasma. De cette façon, la mesure est rendue insensible aux dilatations de la chambre de gravure.

Selon l'invention, le système de mesure de la profondeur du cratère d'érosion comporte une source lumineuse adaptée pour émettre un faisceau lumineux ; un séparateur optique adapté pour séparer spatialement ou angulairement le faisceau lumineux en un premier faisceau incident et un deuxième faisceau incident ; la lampe à décharge luminescente (60) étant adaptée pour fournir un premier chemin optique vers la première zone et un deuxième chemin optique vers la deuxième zone de l'échantillon ; des moyens optiques adaptés pour diriger, respectivement, le premier faisceau incident vers la première zone suivant le premier chemin optique et le deuxième faisceau incident vers la deuxième zone suivant le deuxième chemin optique, de manière à former un premier faisceau réfléchi par réflexion sur la première zone et, respectivement, un deuxième faisceau réfléchi par réflexion sur la deuxième zone, un dispositif de recombinaison optique adapté pour recombiner le premier faisceau réfléchi et le deuxième faisceau réfléchi et pour former un faisceau interférométrique ; des moyens de détection adaptés pour recevoir le faisceau interférométrique et détecter un signal interférométrique en fonction du temps d'exposition de la première zone audit plasma ; des moyens de traitement adaptés pour traiter le signal interférométrique de manière à déterminer la profondeur (d) du cratère d'érosion en fonction du temps d'exposition de la première zone audit plasma, en prenant comme référence de profondeur nulle la seconde zone non exposée au plasma.

Selon un aspect particulier et avantageux de l'invention, les moyens de détection et les moyens de traitement sont adaptés pour traiter le signal interférométrique et pour en extraire une mesure de l'amplitude (A) et de la phase (PHI) du signal interférométrique en fonction du temps d'exposition de la première zone audit plasma.

De préférence, le premier faisceau incident forme un angle d'incidence inférieur à dix degrés par rapport à la normale à la surface de la première zone de l'échantillon, et de préférence non nul et environ égal à cinq degrés.

De façon avantageuse, l'échantillon forme la cathode de la lampe à décharge et la lampe à décharge comporte une anode cylindrique ayant une première ouverture axiale adaptée pour le passage du premier faisceau incident et du premier faisceau réfléchi, et l'anode comporte une deuxième ouverture décalée par rapport à l'axe de l'anode, la deuxième ouverture étant munie d'une fenêtre optique adaptée pour le passage du deuxième faisceau incident et du deuxième faisceau réfléchi.

Selon un aspect de l'invention, le séparateur optique comprend au moins un prisme séparateur de polarisation.

Préférentiellement, le séparateur optique comprend un prisme de Wollaston, le dispositif de recombinaison optique comprend un autre prisme de Wollaston, et les moyens optiques adaptés pour diriger, respectivement, le premier faisceau incident vers la première zone et le deuxième faisceau incident vers la deuxième zone comprennent un système optique à lentille, lesdits prismes de Wollaston étant disposés dans le plan focal de ce système optique à lentille.

Dans un mode de réalisation particulier, le séparateur optique et le dispositif de recombinaison optique sont confondus.

Dans un mode de réalisation, le spectromètre comprend un spectromètre de masse couplé à la lampe à décharge via une ouverture, le spectromètre de masse étant adapté pour mesurer au moins un signal représentatif d'espèces ionisées du plasma de décharge luminescente par spectrométrie de masse.

Dans un autre mode de réalisation, le spectromètre comprend un spectromètre optique couplé à la lampe à décharge via une fenêtre optique ou via un système optique à lentille, le spectromètre optique étant adapté pour mesurer au moins un signal d'émission optique représentatif d'espèces excitées du plasma de décharge luminescente, de préférence dans une direction normale à la surface de la première zone de l'échantillon.

Selon un aspect particulier de ce mode de réalisation, le système de spectrométrie par décharge luminescente comporte un spectromètre optique adapté pour mesurer au moins un signal d'émission optique représentatif d'espèces excitées du plasma de décharge luminescente, et la source lumineuse est adaptée pour émettre un faisceau lumineux à une longueur d'onde sélectionnée en dehors d'une gamme de longueur d'onde de raies atomiques d'émission optique du plasma de décharge luminescente.

Dans une variante particulière et avantageuse, les moyens de détection comprennent un polarimètre adapté pour mesurer au moins une composante polarisée du faisceau interférométrique.

De façon particulièrement avantageuse, ledit polarimètre comprenant d'autres moyens de séparation optique disposés de manière à séparer le faisceau interférométrique en une pluralité de composantes polarisées et une pluralité de détecteurs adaptés pour détecter chacun respectivement une composante polarisée de la pluralité de composantes polarisées du signal interférométrique.

L'invention concerne aussi un procédé de spectrométrie de décharge luminescente et de mesure *in situ* de la profondeur de gravure d'un échantillon selon la revendication indépendante 13. Selon un aspect particulier, le procédé de mesure *in situ* de la profondeur de gravure d'un échantillon comprend en outre les étapes suivantes :

- traitement du signal interférométrique pour en extraire une mesure de la phase (PHI) du signal interférométrique en fonction du temps d'exposition de la première zone audit plasma;
- détermination à chaque instant *t* d'une vitesse instantanée de gravure $V_e$ de la première zone de l'échantillon, par application de la formule suivante :

$$V_e = \frac{LAMBDA}{4 \times \pi} \times \frac{dPHI}{dt}$$

où LAMBDA représente la longueur d'onde de la source lumineuse et dPHI/dt la dérivée par rapport au temps de la phase (PHI) du signal interférométrique mesuré.

Selon un mode de réalisation particulier et avantageux, le plasma de gravure fonctionne en mode impulsionnel, par alternance d'une phase où le plasma est allumé et d'une autre phase où le plasma est éteint, et le procédé de mesure *in situ* de la profondeur de gravure comprend les étapes suivantes :

- la détection du au moins un signal interférométrique est déclenchée pendant les phases où le plasma est allumé et/ou respectivement pendant les phases où le plasma est éteint, de manière à différencier un signal interférométrique associé aux phases où le plasma est allumé d'un autre signal interférométrique associé aux phases où le plasma est éteint,
- traitement du signal interférométrique associé aux phases où le plasma est allumé et/ou respectivement de l'autre signal interférométrique associé aux phases où le plasma est éteint de manière à corriger la mesure de profondeur du cratère d'érosion des dérives induites pendant les phases où le plasma est allumé et/ou respectivement pendant les phases où le plasma est éteint.

Cette description donnée à titre d'exemple non limitatif fera mieux comprendre comment l'invention peut être réalisée en référence aux dessins annexés sur lesquels :

- la figure 1 représente schématiquement un système de mesure *in situ* de la profondeur de gravure d'un échantillon dans un appareil de spectrométrie de décharge luminescente selon un mode de réalisation par spectrométrie d'émission optique ;
- la figure 2 représente schématiquement une vue en coupe d'une lampe à décharge luminescente adaptée selon un exemple de réalisation ;
- la figure 3 représente schématiquement un autre exemple de système de mesure *in situ* de la profondeur de gravure d'un échantillon dans un appareil de spectrométrie de décharge luminescente par spectrométrie d'émission optique ;
- la figure 4 représente schématiquement un exemple de système de mesure *in situ* de la profondeur de gravure d'un échantillon dans un appareil de spectrométrie de décharge luminescente à émission optique selon un autre mode de réalisation.

## Dispositif

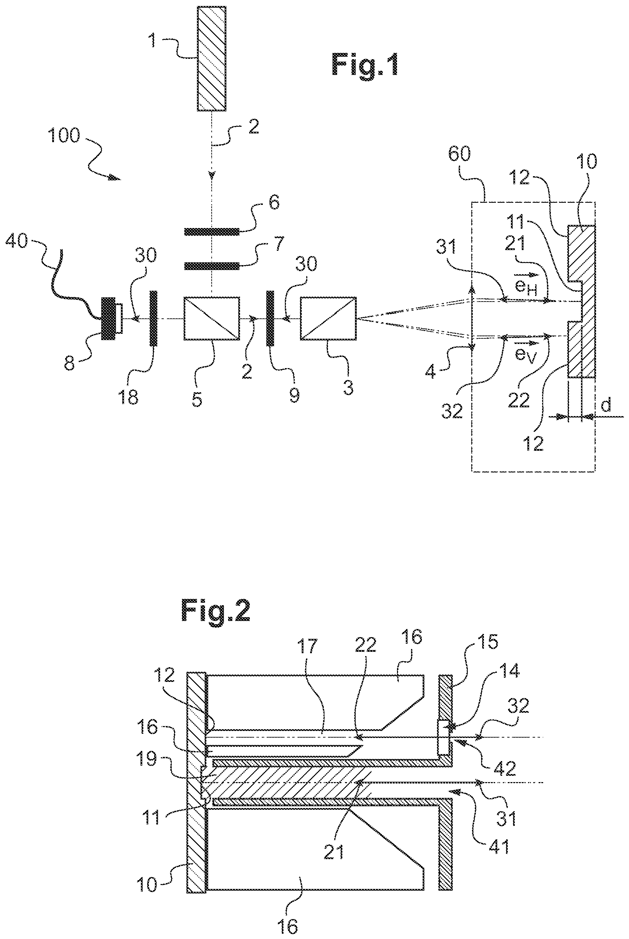

La figure 1 représente schématiquement un système de mesure *in situ* de la profondeur de gravure d'un échantillon dans un appareil de spectrométrie de décharge luminescente (GDS).

On a représenté un échantillon 10 qui est situé dans une chambre de plasma d'un appareil de spectrométrie de décharge luminescente 60.

A titre d'exemple, la lentille 4 ferme hermétiquement une ouverture, par exemple axiale, dans la chambre de gravure de l'appareil de GDS.

L'échantillon présente une face dont une première zone 11 est exposée au plasma de gravure tandis qu'une autre zone 12 est protégée de ce même plasma de gravure.

Le principe de la mesure *in situ* de la profondeur de gravure repose sur l'intégration d'un appareil d'interférométrie optique. Avantageusement, les composants optiques de cet interféromètre sont disposés à l'extérieur de la chambre à plasma de la lampe à décharge.

L'interféromètre comporte essentiellement une source lumineuse, un séparateur optique de faisceau 3 qui sépare le faisceau source en deux faisceaux se propageant suivant deux chemins optiques séparés, un combineur optique de faisceau qui recombine les faisceaux préalablement séparés, un séparateur source-détecteur 5, un détecteur 8 et un système de traitement du signal.

L'exemple de la figure 1 illustre un exemple d'interféromètre optique fonctionnant en lumière polarisée.

Plus précisément, le système de mesure comprend une source 1, qui est par exemple une source laser ou une diode laser. La source lumineuse 1 émet un faisceau lumineux 2, de préférence monochromatique, par exemple à une longueur d'onde de 635 nm, ou encore de 780 nm, 532 nm, 405 nm. Dans l'exemple de la figure 1, on dispose un diaphragme 6, ou trou source, pour limiter l'étendue spatiale du faisceau source 2. Une lame demi-onde (aussi appelée $\lambda/2$) 7 permet de déterminer l'axe de polarisation du faisceau source.

Un séparateur source-détecteur 5, par exemple de type cube séparateur de polarisation, est disposé sur le faisceau source 2. L'orientation de l'axe de la lame demi-onde 7 par rapport aux axes du séparateur 5 permet d'ajuster la puissance du faisceau source 2. De préférence, l'axe de polarisation du polariseur 7 est orienté de manière à ce que les faisceaux incidents séparés 21, 22 aient la même amplitude. Le faisceau interférométrique détecté a une intensité maximum lorsque l'amplitude des faisceaux qui se recombinent est égale.

Dans l'exemple de la figure 1, le séparateur source-détecteur 5 dirige le faisceau source 2 vers une lame $\lambda/2$ (signe de référence 9 sur la figure 1) puis vers un autre séparateur optique de faisceau 3. De façon avantageuse, la lame $\lambda/2$ est orientée de manière à ce que les faisceaux incidents séparés 21, 22 aient la même amplitude. Le faisceau interférométrique détecté a un contraste interférométrique maximum lorsque l'amplitude des faisceaux qui se recombinent est égale. Le séparateur optique 3 est par exemple un cube séparateur de polarisation, dont les axes de polarisation sont inclinés à 45 degrés par rapport à l'axe du faisceau incident 2 polarisé linéairement qui a traversé la lame $\lambda/2$. A titre d'exemple, le séparateur optique 3 est un prisme de Wollaston qui est adapté pour séparer angulairement le faisceau incident en deux faisceaux incidents 21, 22 polarisés linéairement suivant des états de polarisations orthogonaux entre eux. Ainsi, un premier faisceau incident 21 polarisé p- est dirigé dans une première direction et un deuxième faisceau incident 22 polarisé s- est dirigé dans une deuxième direction. Par construction du prisme Wollaston 3, la première direction et la deuxième direction sont séparées angulairement d'un angle compris entre 0.1 et 20 degrés.

La lentille 4 est montée sur une ouverture de la lampe à décharge de manière à assurer l'étanchéité sous vide tout en permettant un accès optique à l'intérieur de la lampe à décharge. De préférence, le séparateur optique 3 est disposé au foyer de la lentille 4. Ainsi, la lentille 4 forme deux faisceaux incidents 21, 22 séparés spatialement qui se propagent parallèlement dans la lampe à décharge 60 en direction d'une face de l'échantillon.

Le faible écartement spatial des faisceaux incidents 21 et 22 permet de les coupler à la lampe à décharge via la lentille 4 déjà présente. Il n'est donc pas nécessaire de réaliser une nouvelle ouverture optique dans l'enceinte de la lampe à décharge 60 pour faire passer deux faisceaux optiques séparés 21 et 22.

Dans une variante, à la place des prismes de Wollaston, on peut utiliser des séparateurs à décalage de faisceau et remplacer la lentille 4 par une fenêtre.

De préférence, l'échantillon présente une face plane qui est destinée à être exposée partiellement au plasma de gravure. La lampe à décharge 60 est adaptée pour permettre au premier faisceau incident 21 de suivre un premier chemin optique en direction d'une première zone 11 de l'échantillon, qui est destinée à être exposée au plasma. D'autre part, la lampe est spécialement adaptée pour permettre au deuxième faisceau incident 22 de suivre un deuxième chemin optique en direction d'une deuxième zone 12 de l'échantillon, qui reste cependant protégée vis-à-vis du plasma de gravure.

Ainsi, la lentille 4 focalise le premier faisceau incident 21 sur la première zone 11 de l'échantillon qui est exposée au plasma de gravure. D'autre part, la lentille 4 focalise le deuxième faisceau incident 22 sur la deuxième zone 12 de l'échantillon qui est protégée du plasma de gravure.

Un exemple de lampe à décharge spécialement adaptée pour permettre ces deux chemins optiques est décrit dans le présent document en lien avec la figure 2.

Par réflexion sur la première zone 11, le premier faisceau incident 21 forme un premier faisceau réfléchi 31. De manière analogue, par réflexion sur la deuxième zone 12, le deuxième faisceau incident 22 forme un deuxième faisceau réfléchi 32. Dans l'exemple illustré sur la figure 1, l'échantillon présente une face plane et la gravure de la première zone 11 génère un cratère à fond plat. De plus, dans cet exemple, les faisceaux incidents 21, 22 se réfléchissent sur l'échantillon sous un angle d'incidence nul. Dans ce cas, le premier faisceau réfléchi 31 se propage dans la direction opposé au premier faisceau incident 21, et, respectivement, le deuxième faisceau réfléchi 32 se propage dans la direction opposé au premier faisceau incident 22.

La lentille 4 collecte le premier faisceau réfléchi 31 et le deuxième faisceau réfléchi 32 et les dirige vers un système optique de recombinaison, qui est ici le même prisme de Wollaston 3 ayant servi à séparer le faisceau incident.

Le prisme de Wollaston recombine le premier faisceau réfléchi 31 et le deuxième faisceau réfléchi 32 pour former un faisceau interférométrique 30. Le faisceau interférométrique traverse la lame $\lambda/2$ et est incident sur le séparateur polarisant source-détecteur 5 qui envoie une composante de polarisation du faisceau interférométrique en direction d'un filtre 18 et d'un détecteur 8. Comme indiqué plus haut, l'orientation de la lame 9 est telle que la polarisation du faisceau incident 2 est à 45° des axes du prisme deWollaston 3. Cette disposition a pour effet bénéfique que le couple constitué de la lame 9 et du séparateur 5 forme, dans le sens du retour, un analyseur de polarisation à 45° des axes du prisme de Wollaston 3, ce qui permet effectivement de générer un signal interférométrique par somme des amplitudes des faisceaux 31 et 32.

Le filtre 18 est un filtre spectral, de préférence centré sur la longueur d'onde d'émission de la source lumineuse 1. Le filtre 18 permet d'éliminer la lumière parasite provenant du plasma ou de l'éclairage ambiant. Le filtre 18 est par exemple un filtre interférentiel centré à 635 nm d'une largeur spectrale de 10 nm.

Le détecteur 8 détecte un signal interférométrique 40 en fonction du temps. Un système de traitement permet de traiter numériquement ce signal interférométrique 40 de manière à en extraire une information sur l'amplitude et la phase du signal interférométrique.

Au cours de la gravure de la première zone 11 de l'échantillon, le premier chemin optique s'allonge, tandis que le deuxième chemin optique reste stable. La différence de chemin optique augmente donc en fonction de la gravure de la première zone 11 de l'échantillon. Ainsi, le détecteur détecte un signal interférométrique 40 dont l'intensité est représentative de la profondeur de gravure de la première zone 11 de l'échantillon. Le premier chemin optique forme le bras de mesure de l'interféromètre : il va du séparateur-combineur de faisceau 3 à la première zone 11 de l'échantillon et revient au séparateur-combineur de faisceau 3. Le deuxième chemin optique forme le bras de référence de l'interféromètre : il va du séparateur-combineur de faisceau 3 à la deuxième zone 12 de l'échantillon et revient au séparateur-combineur de faisceau 3.

De manière connue par ailleurs, dans le cas d'un échantillon opaque et homogène, l'analyse du signal interférométrique permet de déterminer la profondeur de gravure dans l'échantillon. En effet dans ce cas, le signal interférométrique présente une forme sinusoïdale en fonction du temps. Le nombre de périodes de la courbe d'intensité permet de déterminer la profondeur de gravure, connaissant la longueur d'onde du faisceau source. L'erreur de mesure interférométrique de la profondeur ainsi obtenue est de l'ordre de $\lambda/8$, où $\lambda$ est la longueur d'onde du faisceau source.

Pendant la pulvérisation de l'échantillon la profondeur du cratère augmente et donc la différence de phase entre les deux ondes réfléchies 31, 32 varie en fonction du temps t.

Plus précisément, notons $\delta(t)$ le déphasage relatif entre le premier faisceau réfléchi 31 et le deuxième faisceau réfléchi 32.

$$\delta(t) = 2kd(t) + \varphi_H - \varphi_V$$

où $k=2\pi/\lambda$, $d(t)$ représente la profondeur de gravure en fonction du temps.

On exprime par les relations suivantes $r_V$ le coefficient de réflexion sur la première zone 11 et $r_H$ le coefficient de réflexion sur la deuxième zone 12 :

$$r_V = \rho_V \exp(i\varphi_V)$$

$$r_H = \rho_H \exp(i\varphi_H)$$

On note $I(t)$ l'intensité du faisceau interférométrique en fonction du temps, $E_V$ l'amplitude du champ électrique relatif au faisceau incident 21 sur la première zone 11, c'est-à-dire dans le cratère, $E_H$ l'amplitude du champ électrique relatif au faisceau incident 22 sur la deuxième zone 12. L'intensité du signal interférométrique détecté s'écrit selon la

relation suivante :

$$I(t) = \frac{1}{2}\left(E_{T}^{2}\rho_{T}^{2} + E_{R}^{2}\rho_{R}^{2} + 2E_{T}E_{R}\rho_{T}\rho_{R}\cos(\delta(t))\right)$$

Si la vitesse de gravure est constante, la différence de chemin optique augmente linéairement et donc l'intensité détectée varie sinusoïdalement en fonction du temps. Dans le cas d'un matériau homogène, le résultat d'une série de mesures interférométriques en fonction du temps est alors un ensemble de points sur une courbe sinusoïdale. Pour un échantillon comportant un empilement multicouche de différents matériaux, la vitesse de gravure dépend en général de la composition de chaque couche. Si les couches sont opaques, la série de points mesurés forme par interpolation une courbe expérimentale constituée par morceaux de sinusoïdes de différentes périodes.

Pour déterminer la profondeur d(t) du cratère gravé, on estime le nombre de périodes détectées depuis le début de la gravure. En effet une période complète de sinusoïde équivaut en terme de longueur à une longueur d'onde λ de la source lumineuse (par ex. le laser) utilisée. Or la différence de chemin optique entre les deux ondes est à chaque instant égal au double de la profondeur du cratère gravé. Chaque période sur la courbe d'intensité correspond donc à une profondeur gravée égale à λ/2.

Entre le début de la gravure et un instant t, si le nombre de périodes sur la courbe de mesure d'intensité I(t) est égal à un nombre entier N, alors la profondeur gravée du cratère est égale à N*λ/2.

Pour un échantillon homogène, une simple estimation visuelle du nombre de périodes sur la courbe d'intensité du signal interférométrique I(t) permet ainsi de déterminer la profondeur de gravure avec une précision de l'ordre de λ/8, qui correspond dans le cas du laser utilisé à environ 80 nm. Pour une meilleure précision, il est aussi possible de déterminer la fréquence de la courbe d'intensité en utilisant un fit, par exemple par une fonction sinusoïdale. Ceci permet d'obtenir une précision encore plus importante sur la profondeur de gravure.

Toutefois, dans le cas où l'échantillon comporte un empilement de couches minces et/ou transparentes, la mesure du signal d'intensité I(t) du faisceau interférométrique en fonction du temps n'offre qu'une précision et une sensibilité limitées.

Généralement, la chambre à plasma d'une lampe à décharge ne présente qu'un seul accès optique permettant un chemin optique d'ordinaire limité à la première zone 11 exposée au plasma de gravure. Le document de brevet FR1250594 décrit un exemple de lampe à décharge luminescente comportant une anode cylindrique creuse et un unique accès optique sur l'axe de l'anode.

La figure 2 représente schématiquement une vue en coupe d'une lampe à décharge adaptée spécialement à un système interférométrique selon un exemple de réalisation.

La lampe à décharge comporte une anode 15, une cathode formée par l'échantillon 10 lui-même, et une pièce électriquement isolante 16 disposée entre l'anode 15 et l'échantillon 10. L'anode 15 présente une forme générale cylindrique illustrée sur la figure 2 en coupe le long de l'axe du cylindre. La pièce électriquement isolante 16 présente aussi une forme cylindrique, et comporte une ouverture cylindrique coaxiale dans laquelle est insérée l'anode. La pièce 16 permet de positionner précisément l'anode par rapport à la cathode. L'extrémité tubulaire de l'anode 15 est ainsi positionnée à quelques dixièmes de millimètres de la surface de l'échantillon. Le gaz porteur du plasma, qui est en général un gaz rare, est injecté par l'intérieur de l'anode, et les gaz sont évacués par l'espace entre l'extrémité de l'anode et la surface de l'échantillon. Le positionnement précis de l'anode 15, de la pièce isolante 16 et de l'échantillon 10 permet de confiner le plasma dans une zone centrale tubulaire à l'intérieur de l'anode. La pièce isolante 16 est généralement en contact avec la face de l'échantillon en dehors de la zone 11 exposée au plasma de gravure de manière à protéger la face de l'échantillon en dehors de la première zone 11. La lampe à décharge permet ainsi à un plasma 19 de graver sélectivement la première zone 11 de l'échantillon qui fait face à l'extrémité tubulaire de l'anode 15.

L'ouverture axiale 41 de l'anode fournit un premier chemin optique vers une première zone 11 de l'échantillon qui est exposée au plasma 19. Par retour inverse, le premier faisceau réfléchi 31 sous incidence normale sur la première zone 11, se propage suivant le même chemin optique. Dans le cas de la spectrométrie d'émission optique, ce premier chemin optique est aussi utilisé pour collecter un faisceau d'émission optique émis par le plasma 19.

Dans l'exemple illustré sur la figure 2, la lampe à décharge est spécialement adaptée pour fournir un deuxième chemin optique vers une deuxième zone 12 de l'échantillon qui est protégée vis-à-vis du plasma 19. Plus précisément, on a formé d'une part dans l'anode 15 une ouverture 42, qui est munie d'une fenêtre optique 14 et d'autre part une ouverture 17 dans la pièce isolante 16. L'ouverture 42 et l'ouverture 17 sont alignées, par exemple suivant un axe décalé et de préférence parallèle à l'axe de l'anode 15. Ainsi, l'ouverture axiale 41 et l'ouverture hors d'axe 17 ne communiquent pas entre elles. La fenêtre 14 limite les fuites de gaz et ou du plasma en direction de la deuxième zone 12 de l'échantillon. La fenêtre 14 est par exemple une lame de verre à faces planes et parallèles.

L'ouverture 42, la fenêtre optique 14 et l'ouverture 17 permettent de diriger le deuxième faisceau incident 22 vers la deuxième zone 12 de l'échantillon.

On définit ainsi un deuxième chemin optique passant par la fenêtre optique 14 et allant jusqu'à une deuxième zone 12 de l'échantillon qui reste protégée du plasma de gravure 19. Le deuxième faisceau incident 22 peut dès lors être dirigé à travers la fenêtre 14 et l'ouverture 17 vers la deuxième zone 12 de l'échantillon, qui est séparée spatialement de la première zone 11, mais qui est située sur la même face de l'échantillon 10.

Le deuxième faisceau réfléchi 32 suit de préférence le deuxième chemin optique en sens opposé vers la fenêtre optique 14.

Ainsi, le premier faisceau et le deuxième faisceau suivent des chemins optiques séparés, tout en étant réfléchis sur une même face de l'échantillon.

Cette configuration permet de limiter les dérives du signal interférométrique dues aux dilatations de la lampe à décharge induites par l'échauffement du plasma.

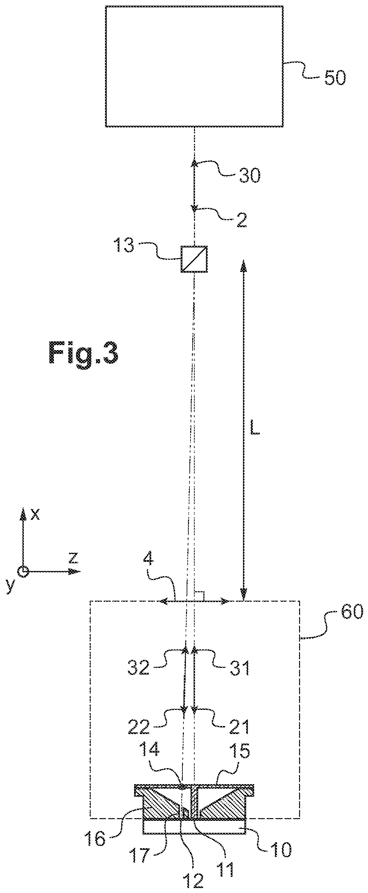

La figure 3 illustre un autre exemple de système de mesure *in situ* de la profondeur de gravure d'un échantillon dans un appareil de spectrométrie de décharge luminescente.

Le système comporte un bloc 50 qui comprend au moins une source lumineuse et au moins un détecteur situé à l'extérieur d'une lampe à décharge 60.

La lampe à décharge 60 comprend une anode cylindrique 15, de section tubulaire creuse, une pièce électriquement isolante 16 et un échantillon 10 formant la cathode de la lampe à décharge. Une lentille 4 est par exemple mise en place sur une ouverture de l'enceinte à vide de la lampe à décharge 60. De préférence, la lentille 4 est disposée sur l'axe de l'anode 15.

L'anode 15 est similaire à celle décrite en lien avec la figure 2. Cette anode 15 est de forme cylindrique et comporte une ouverture axiale formant un premier chemin optique entre chemin optique entre le bloc source-détecteur 50 et la première zone 11 de l'échantillon 10 qui est exposée au plasma de gravure.

L'anode 15 de la lampe à décharge comporte une autre ouverture, décalée par rapport à l'axe de l'anode 15, et munie d'une fenêtre optique 14. La pièce électriquement isolante 16 disposée entre l'anode 15 et l'échantillon 10 comporte un trou cylindrique, de manière à former un deuxième chemin optique entre le bloc source-détecteur 50 et la deuxième zone 12 de l'échantillon 10 qui est protégée vis-à-vis du plasma de gravure.

Dans l'exemple illustré sur la figure 3, l'échantillon est plan, et disposé dans le plan YZ d'un repère orthonormé (X, Y, Z). La normale au plan de l'échantillon est parallèle à l'axe X. On suppose que le plasma de gravure génère un cratère d'érosion à fond plat sur la première zone 11 de l'échantillon 10.

Un séparateur-combineur de faisceau 13 est disposé sur le chemin optique du faisceau source 2 entre le bloc source-détecteur 50 et la lampe à décharge 60. Par exemple, le séparateur-combineur de faisceau 13 est constitué d'un prisme de Wollaston. Le prisme de Wollaston 13 sépare angulairement le faisceau incident 2 en un premier faisceau incident 21 et un deuxième faisceau incident 22, par exemple d'un angle compris entre 0.1 et 10 degrés, et de préférence d'environ 1 degré.

Le séparateur-combineur de faisceau 13 est placé à une distance L d'une lentille 4. De préférence, la distance L est égale à la distance focale de la lentille 4, de manière à ce que le séparateur-combineur de faisceau 13 soit dans le plan focal de la lentille 4.

La lentille 4 dirige le premier faisceau incident 21 le long de l'axe de l'anode 15, parallèle à l'axe X, vers la première zone 11 de l'échantillon. Par réflexion sur cette première zone 11, un premier faisceau réfléchi 31 est renvoyé en direction de la lentille 4.

Simultanément, la lentille 4 dirige le deuxième faisceau incident 22 vers la fenêtre optique 14 et l'ouverture 17 le long du deuxième chemin optique vers la deuxième zone 12 de l'échantillon. Par réflexion sur cette deuxième zone 12, un deuxième faisceau réfléchi 32 est renvoyé en direction de la lentille 4.

Le prisme 3 étant dans le plan focal de la lentille 4, les faisceaux incidents 21 et 22 sont parallèles entre eux et parallèles à l'axe X dans la lampe à décharge 60. De même, les faisceaux réfléchis 31 et 32 sont en général parallèles entre eux et parallèles à l'axe X dans la lampe à décharge 60.

La lentille 4 focalise les premier et deuxième faisceaux réfléchis 31, 32 sur le prisme de Wollaston 13, qui les recombine en un faisceau interférométrique 30 en direction d'un détecteur dans le bloc source-détecteur 50. La disposition du prisme 13 dans le plan focal de la lentille 4 permet la recombinaison des premier et deuxième faisceaux réfléchis 31, 32 du point de vue géométrique.

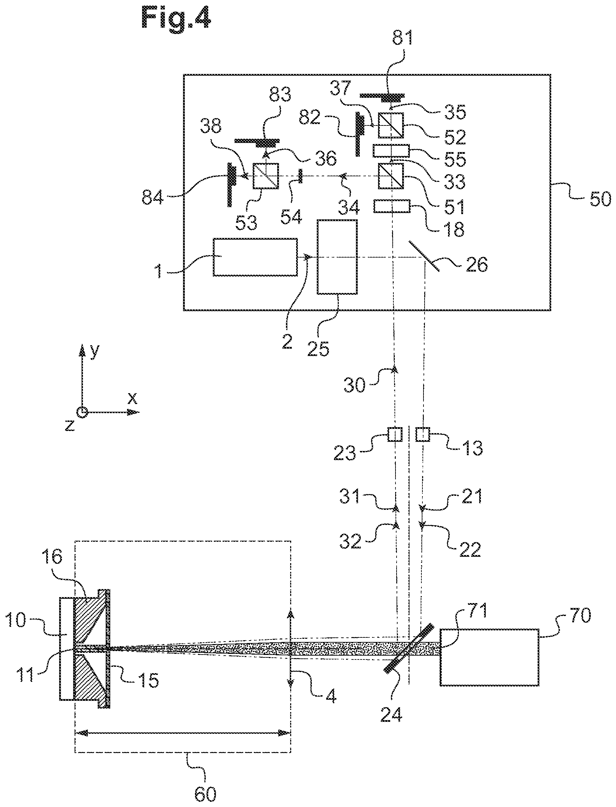

La figure 4 représente schématiquement un deuxième mode de réalisation de système de mesure *in situ* de la profondeur de gravure d'un échantillon couplé à un appareil de spectrométrie de décharge luminescente à émission optique.

Dans ce deuxième mode de réalisation, le système de mesure de la profondeur de gravure n'est pas un simple interféromètre mais un interféromètre polarimétrique.

Sur la figure 4, les mêmes éléments que ceux de la figure 3 sont indiqués par les mêmes signes de référence.

L'appareil de la figure 4 comporte une lampe à décharge 60, un bloc source-détecteur 50 et un système optique à miroirs et/ou à lentilles disposé entre la lampe à décharge 60 et le bloc source-détecteur 50.

Dans l'exemple illustré sur la figure 4, l'échantillon 10 est plan, et disposé dans le plan YZ d'un repère orthonormé (X, Y, Z). La normale au plan de l'échantillon est parallèle à l'axe X.

Le bloc source-détecteur 50 comporte une source lumineuse 1, par exemple un laser ou une diode laser. Un isolateur optique 25 est disposé sur le faisceau source 2.

Un système optique comportant ici des miroirs plans 24 et 26 permet de diriger le faisceau source vers la lentille 4 disposée sur l'axe de la lampe à décharge 60.

De façon particulièrement avantageuse, le miroir 26 comporte une ouverture axiale permettant le passage d'un faisceau d'émission optique 71 émis par le plasma de décharge luminescente vers un spectromètre d'émission optique 70.

Le système de la figure 4 comporte en outre un séparateur de faisceau 13 et un combineur de faisceau 23. Le séparateur de faisceau 13 est disposé sur le chemin optique du faisceau source 2. Le combineur de faisceau 23 est disposé sur le chemin optique des faisceaux réfléchis 31, 32. Par exemple, le séparateur de faisceau 13 est un prisme de Wollaston et le combineur de faisceau 23 est un autre prisme de Wollaston. L'avantage d'une configuration à deux prismes est de permettre l'utilisation de prismes de petite dimension, qui sont peu encombrants et peu coûteux.

En variante, comme illustré en lien avec la figure 3, le séparateur-combineur de faisceau peut être constitué d'un seul et même prisme, de dimension plus grande.

Le miroir 26 réfléchit le faisceau source 2 en direction du prisme séparateur 13. Avantageusement, le miroir 26 est monté sur une platine réglable en orientation autour d'un axe OZ et d'un axe à 45° des axes OX et OY. Le prisme séparateur 13 sépare angulairement le faisceau source 2 en un premier faisceau incident 21 et un deuxième faisceau incident 22. Le prisme 13 est construit de manière à ce que les faisceaux incidents 21 et 22 soient séparés angulairement dans un plan YZ d'un angle compris entre 0.1 et 20 degrés, par exemple 2 degrés. Le miroir 26 réfléchit les faisceaux incidents 21 et 22 vers la lentille 4. Dans l'exemple illustré sur la figure 4, les faisceaux incidents 21 et 22 entre la lentille 4 et l'échantillon, sont inclinés par rapport à l'axe de la lentille 4, c'est-à-dire par rapport à la normale à la surface de l'échantillon, d'un angle compris entre 1 et 20 degrés dans le plan XY.

La lampe à décharge 60 est similaire à celle décrite en lien avec la figure 2 ou la figure 3. La lampe à décharge comporte en particulier une lentille 4 disposée sur l'axe de l'anode cylindrique creuse 15, formant un premier chemin optique vers la première zone 11 de l'échantillon 10, qui est exposée au plasma de décharge luminescente à l'extrémité du tube anodique. L'anode comporte aussi une autre ouverture hors d'axe, par exemple dans un plan XZ, alignée sur un une ouverture cylindrique dans la pièce intermédiaire 16 de manière à former un deuxième chemin optique vers la deuxième zone 12 de l'échantillon. Sur la figure 4, la deuxième zone 12 n'apparaît pas, car elle est située dans un plan transverse au plan de la figure 4.

D'une part, la lentille 4 focalise le premier faisceau incident 21 sur la première zone 11 de l'échantillon qui fait face à l'extrémité tubulaire de l'anode 15 et qui est exposée au plasma de gravure. D'autre part, la lentille 4 focalise le deuxième faisceau incident 22 sur la deuxième zone 12 de l'échantillon via le deuxième chemin optique qui passe à travers l'anode 15 par une fenêtre optique hors d'axe 14 et à travers la pièce intermédiaire 16 par une ouverture 17 hors d'axe. La deuxième zone 12 de l'échantillon est donc protégée du plasma de gravure.

Le premier faisceau incident 21 forme par réflexion sur la première zone 11 un faisceau réfléchi 31, qui est incliné symétriquement au faisceau incident par rapport à la normale à l'échantillon. De manière similaire, le deuxième faisceau incident 22 forme, par réflexion sur la deuxième zone 12, un faisceau réfléchi 32 qui est incliné symétriquement au faisceau incident par rapport à la normale à l'échantillon. Ainsi, le faisceau réfléchi 31 se propage le long d'un chemin optique séparé angulairement du faisceau incident 21. De même, le faisceau réfléchi 32 se propage le long d'un chemin optique séparé angulairement du faisceau incident 22. De plus, le premier et le deuxième faisceau réfléchi sont séparés spatialement et se propagent dans la lampe à décharge suivant des chemins optiques spatialement distincts.

La lentille 4 collecte le premier faisceau réfléchi 31 et le deuxième faisceau réfléchi 32, qui apparaissent superposés sur la figure 4, mais sont en réalité décalés dans un plan YZ. Le miroir 24 réfléchit les premier et deuxième faisceaux réfléchis 31, 32 vers un prisme combineur de faisceau 23. La lentille 4 focalise les premier et deuxième faisceaux réfléchis 31, 32 sur le combineur de faisceau 23, de manière à les superposer géométriquement.

Le combineur de faisceau 23 recombine optiquement les premier et deuxième faisceaux réfléchis 31, 32 et forme ainsi un faisceau interférométrique 30 en direction du bloc source-détecteur 50. Le bloc source-détecteur comporte un filtre 18, par exemple de type filtre interférométrique, qui permet d'éliminer l'émission parasite du plasma ou de l'éclairage ambiant.

Le système de détection de la figure 4 diffère de ceux décrits en lien avec les figures 1 et 3 en ce qu'il comporte un système de détection polarimétrique. Plus précisément, ce système de détection polarimétrique comporte un séparateur non polarisant 51, un premier séparateur de polarisation 52 et un deuxième séparateur de polarisation 53, une lame quart d'onde 54, un rotateur de polarisation 33 et quatre détecteurs 81, 82, 83, 84. Dans un mode de réalisation alternatif, les positions des éléments 54 et 33 peuvent être interverties.

Avantageusement, le séparateur non polarisant 51 préservera au mieux l'état de polarisation du faisceau incident à la fois sur les voies transmise et réfléchie. A ce titre les séparateurs non polarisant pour laser, optimisés pour une plage de longueur d'onde étroite seront préférables aux séparateurs large bande, couvrant par exemple tout le visible.

Le rotateur de polarisation 55 associé au séparateur de polarisation 52 forme un analyseur de polarisations linéaires orientées à 45° des axes des séparateurs recombineurs 13 et 23. Le détecteur 81 détecte une composante 35 de polarisation du faisceau interférométrique 30 à +45° et le détecteur 82 détecte une composante 37 de polarisation du faisceau interférométrique 30 à -45° des axes de 13et 23.

La lame quart-d'onde 54 associée au séparateur de polarisation 53 forme un analyseur de polarisations circulaires, respectivement 36 circulaire droite et 38 circulaire gauche. Le détecteur 83 détecte la composante 36 de polarisation circulaire droite du faisceau interférométrique 30 et le détecteur 84 détecte la composante 38 de polarisation circulaire gauche du faisceau interférométrique 30.

Ainsi, le système de détection de la figure 4 permet de détecter simultanément les quatre composantes de polarisation du faisceau interférométrique 30.

A partir des quatre signaux détectés par les quatre détecteurs 81, 82, 83, 84, il est possible d'en déduire le déphasage entre le faisceau réfléchi 31 par la première zone 11, c'est-à-dire dans le cratère résultant de la gravure de l'échantillon, et le faisceau réfléchi 32 par la deuxième zone 12, qui sert de référence. De même, la variation du coefficient de réflexion de la première zone, peut être calculée à partir de la mesure des deux composantes de polarisation linéaire ou des deux composantes de polarisation circulaire.

L'analyse des signaux interférométriques se base sur l'approche classique. Dans le cas où l'échantillon est constitué d'un matériau homogène et absorbant, on peut faire l'hypothèse d'un milieu semi-infini. Dans le cas où l'échantillon comporte un empilement de couches minces et/ou transparentes à la longueur d'onde de mesure, l'analyse se fonde sur des calculs numériques de simulation et de minimisation d'une fonction d'erreur.

Un système de mesure tel qu'illustré sur la figure 4 fournit quatre mesures simultanées en fonction du temps. L'ensemble des mesures des quatre détecteurs fournit par interpolation quatre courbes qui peuvent être analysées soit en temps réel, pour un échantillon homogène, soit après l'acquisition de toutes les mesures, pour un échantillon comportant un empilement de couches. Connaissant les coefficients de réfraction et d'absorption optique d'un matériau à la longueur d'onde de mesure, il est possible de modéliser l'intensité et la phase du faisceau interférométrique en fonction de la vitesse de gravure et du temps. En intégrant la vitesse de gravure, on obtient la profondeur de gravure dans l'échantillon en fonction du temps t.

L'analyse de ces courbes permet d'en déduire une mesure de la vitesse de gravure dans un matériau ou une couche. L'apparition d'une discontinuité sur une courbe permet de détecter la gravure d'une interface entre deux couches ou deux matériaux différents dans un échantillon.

Plus précisément, on note $I_{L_1}$ l'intensité de la composante linéaire du faisceau interférométrique selon une direction à 45 degrés par rapport à la polarisation linéaire H du champ incident sur la première zone 11 et par rapport à la polarisation linéaire V du champ incident sur la deuxième zone 12. Le détecteur 81 mesure l'intensité du faisceau 35, c'est-à-dire $I_{L_1}$.

On notre $I_{L_2}$ l'intensité de la composante linéaire du faisceau interférométrique selon une direction de -45 degrés par rapport à la polarisation linéaire H du champ incident sur la première zone 11 et par rapport à la polarisation linéaire V du champ incident sur la deuxième zone 12. Le détecteur 82 mesure l'intensité du faisceau 37, c'est-à-dire $I_{L_2}$.

On note $I_{C_1}$ l'intensité de la composante circulaire droite du faisceau interférométrique. Le détecteur 83 mesure l'intensité du faisceau 36, c'est-à-dire $I_{C_1}$

On notre $I_{C_2}$ l'intensité de la composante circulaire gauche du faisceau interférométrique. Le détecteur 84 mesure l'intensité du faisceau 38, c'est-à-dire $I_{C_2}$

On calcule la différence d'intensité normalisée L entre les intensités détectées sur les voies linéaires :

$$L = \frac{I_{L_1} - I_{L_2}}{I_{L_1} + I_{L_2}} = \frac{2E_V E_H \rho_V \rho_H \cos(\delta)}{E_V^2 \rho_V^2 + E_H^2 \rho_H^2}$$

De même, on calcule la différence d'intensité normalisée C entre les intensités détectées sur les voies circulaires :

$$C = \frac{I_{C_2} - I_{C_1}}{I_{C_2} + I_{C_1}} = \frac{2E_V E_H \rho_V \rho_H \sin(\delta)}{E_V^2 \rho_V^2 + E_H^2 \rho_H^2}$$

On montre que la différence de phase entre les ondes réfléchies 31 et 32 s'écrit :

$$\delta(t) = \arctan\left( \frac{I_{C_2} - I_{C_1}}{I_{C_2} + I_{C_1}} \cdot \frac{I_{L_1} + I_{L_2}}{I_{L_1} - I_{L_2}} \right)$$

La variation de la réflectivité R(t) du cratère au cours du temps peut être également déduite à partir de la mesure des deux composante linéaires $I_{L1}$ et $I_{L2}$ (ou en variante à partir des deux composantes circulaires $I_{C1}$ et $I_{C2}$) en connaissant l'intensité des deux voies choisies à t = 0 s'exprime suivant la relation :

$$R(t) \propto I_{L_1}(t) + I_{L_2}(t) - \left( \frac{I_{L_1}(0) + I_{L_2}(0)}{2} \right)$$

Alternativement, on peut définir l'angle $\Psi$ tel $\tan(\Psi) = \rho_H / \rho_V$. On peut alors déduire les variations de réflectivité $\rho_H / \rho_V$ à partir des mesures par la relation $\sin^2(2\psi) = C^2 + L^2$.

### Couches épaisses et opaques

Dans le cas d'un échantillon ou d'une couche de matériau opaque, la profondeur d(t) du cratère gravé est obtenue à partir de la variation de la phase en fonction du temps par rapport à la valeur initiale :

$$d(t) = \frac{\lambda}{4\pi} [\delta(t) - \delta(0)] = \frac{\lambda}{4\pi} \left[ \arctan\left( \frac{C(t)}{L(t)} \right) - \arctan\left( \frac{C(0)}{L(0)} \right) \right]$$

Ainsi, la mesure des intensités des quatre composantes de polarisation permet de déduire directement la profondeur d(t) du cratère en fonction du temps d'exposition au plasma de gravure.

La pente locale de d(t) indique la vitesse de gravure instantanée.

La réflectivité est liée à l'indice de la surface de l'échantillon.

Le deuxième mode de réalisation a l'avantage de permettre d'accéder directement à la différence de phase entre les deux ondes sans avoir besoin d'un fit sinusoïdal, en général très peu précis lorsque la profondeur de gravure d(t) est inférieure à une période.

### Couches minces ou transparentes

Si l'échantillon comporte un empilement de couches d'un matériau transparent, tel que la silice ou de couches absorbantes mais peu épaisses, comme dans le cas des disques durs, il n'existe pas de relation simple entre profondeur gravée et différence de phase. En effet les faisceaux réfléchis sur l'échantillon subissent des réflexions multiples aux interfaces entre les différentes couches. Le faisceau interférométrique détecté est la résultante de la superposition de toutes ces réflexions. Le faisceau interférométrique détecté est modulé en phase et en intensité au cours de la gravure.

En présence de couches transparentes ou très fines, l'estimation de la profondeur s'appuie alors sur un modèle numérique de l'échantillon construit à partir de la connaissance des matériaux constituant les différentes couches. Ce modèle prend en compte les réflexions multiples des faisceaux laser aux niveaux de l'échantillon et permet de calculer la phase et la réflectivité des ondes réfléchies à chaque instant de la gravure.

La phase et la réflectivité de l'onde réfléchie sont calculées en considérant la propagation de l'onde dans l'échantillon, qui peut être décrite par un formalisme de matrices (voir par exemple P. Yeh, Optical waves in layered média, 1988, Wiley).

L'analyse de la gravure d'un échantillon repose ensuite sur des calculs de simulation du modèle numérique, sur une comparaison avec les mesures d'intensité des différentes composantes de polarisation en fonction du temps et d'une minimisation de l'écart entre les calculs de simulation et les mesures. Par exemple, la minimisation peut être utilisée sur une régression des moindres carrés utilisant comme paramètre ajustable la vitesse de gravure de chaque couche, pour permettre d'estimer par approximations successives les valeurs qui donnent les courbes de phase et réflectivité qui s'adaptent le mieux à celles expérimentales. La régression aux moindres carrés peut se faire en minimisant l'écart entre les courbes théorique et expérimentale soit de la phase seule, soit de la réflectivité seule, soit de la phase et de la réflectivité au même temps. Il est possible aussi de choisir des minimisations différentes pour chaque couche. Le choix entre ces différentes variantes dépend en général de la structure de l'échantillon analysé et des caractéristiques des couches analysées.

Un écart entre les calculs et les mesures permet de raffiner le modèle numérique et de déceler par exemple la présence de couches intermédiaires, qui présentent un gradient d'indice entre deux matériaux superposés.

On a comparé les résultats de mesures interférométriques ainsi obtenues et des résultats de mesures ellipsométriques prises sur les mêmes échantillons. Les épaisseurs obtenues par interférométrie polarimétrique (dispositif selon le deuxième mode de réalisation) et par ellipsométrie sont très proches, l'écart entre les mesures par interférométrie polarimétrique (sous incidence quasi-normale) et par ellipsométrie étant en général inférieures à 5%.

Le système de mesure interférométrique, de préférence polarimétrique permet ainsi de mesurer la profondeur de gravure d(t) dans un échantillon en fonction de la durée d'exposition au plasma de gravure. On peut ainsi évaluer la vitesse de gravure de chaque échantillon, et plus précisément la vitesse de gravure de chaque couche d'un échantillon formé d'un empilement de couches.

Il devient ainsi possible de corriger les mesures de spectrométrie d'émission détectées en fonction du temps t de gravure, pour les analyser et les représenter en fonction de la profondeur de gravure dans l'échantillon.

De façon avantageuse, la mesure de profondeur de gravure détaillée ci-dessus s'applique à un plasma fonctionnant en mode impulsionnel ou pulsé. Le mode pulsé est utilisé couramment pour éviter de chauffer excessivement un échantillon fragile, comprenant par exemple un matériau ou une couche de polymère. En mode pulsé, le plasma est alternativement allumé (on) puis éteint (off) avec une fréquence et un rapport cyclique prédéterminés. L'érosion ne se produit que pendant la phase où le plasma est allumé (on).

Deux modes de réalisation sont envisagés ici plus particulièrement pour améliorer la précision de mesure de profondeur de gravure.

Dans un premier cas, des sources permanentes de perturbation peuvent être à l'origine de dérives des signaux pendant les phases de plasma on et off. Dans ce cas, on mesure la dérive résiduelle du signal interférométrique dans les phases de plasma off, où il n'y a pas de gravure, et où l'on mesure donc uniquement une dérive du signal. On peut ainsi corriger ces dérives en les interpolant dans les phases de plasma on.

Dans un autre cas, des sources intermittentes de perturbation sont à l'origine de dérives résiduelles spécifiques uniquement pendant la phase de plasma allumé, par exemple des dérives induites thermiquement par le plasma. Dans ce cas, on mesure le signal interférométrique uniquement pendant les phases de plasma off, où il n'y a pas dérive du signal. On utilise ces mesures de signal interférométrique pendant les phases plasma off pour en déduire, par exemple par interpolation, la profondeur de gravure en fonction du temps.

Le choix de l'une ou l'autre des méthodes exposées ci-dessus dépend de l'amplitude relative des dérives permanentes et intermittentes.

Le système de l'invention permet ainsi de fournir des mesures par spectrométrie de décharge luminescente en fonction d'une mesure fiable de la profondeur de gravure d(t) dans un échantillon, et non pas seulement en fonction du temps.

L'acquisition des signaux interférométriques est effectuée *in situ* et simultanément avec l'acquisition des mesures par spectrométrie d'émission ou spectrométrie de masse. Le système de mesure illustré en lien avec la figure 4 permet de déterminer précisément la profondeur de gravure dans un échantillon ou dans les couches d'un échantillon en fonction du temps d'exposition au plasma de gravure.

La combinaison de la spectrométrie d'émission optique (ou de masse) et de la mesure interférométrique permet de rapporter l'analyse de la composition élémentaire d'un échantillon à la profondeur de gravure dans cet échantillon de manière extrêmement précise.

Le système de mesure interférométrique de l'invention est peu sensible au bruit mécanique, par exemple des dispositifs de pompe à vide et peu sensible aux dérives thermiques induites par l'échauffement du au plasma d'ablation.

## Revendications

1. Système de spectrométrie de décharge luminescente et de mesure *in situ* de la profondeur de gravure d'un échantillon comprenant :

   - une lampe à décharge luminescente (60) adaptée pour recevoir un échantillon (10) solide et former un plasma (19) de gravure par décharge luminescente, l'échantillon (10) ayant, sur une même face, une première zone (11) exposée au plasma de gravure et une deuxième zone (12) protégée vis-à-vis du plasma de gravure, la lampe à décharge luminescente (60) étant adaptée pour fournir un premier chemin optique vers la première zone (11) et un deuxième chemin optique vers la deuxième zone (12) de l'échantillon, la lampe à décharge comporte une anode (15) cylindrique ayant une première ouverture axiale (41) adaptée pour le passage d'un premier faisceau incident (21), et dans lequel l'anode (15) comporte une deuxième ouverture (42) décalée par rapport à l'axe de l'anode (15), la deuxième ouverture (42) étant adaptée pour le passage d'un deuxième faisceau incident (22);

- un spectromètre couplé à la lampe à décharge luminescente (60), le spectromètre étant adapté pour mesurer, en fonction du temps d'exposition de la première zone (11) audit plasma, au moins un signal représentatif du plasma de décharge luminescente (19) par spectrométrie d'émission optique et/ou par spectrométrie de masse ;

- un système (100) de mesure *in situ* de la profondeur du cratère d'érosion généré par gravure de la première zone (11) de l'échantillon (10) en fonction du temps d'exposition audit plasma ;

le système (100) de mesure de la profondeur du cratère d'érosion comportant:

- une source lumineuse (1) adaptée pour émettre un faisceau lumineux (2) ;

- un séparateur optique (3, 13, 23) adapté pour séparer spatialement ou angulairement le faisceau lumineux (2) en le premier faisceau incident (21) et le deuxième faisceau incident (22) ;

- des moyens optiques (4, 14, 24) adaptés pour diriger, respectivement, le premier faisceau incident (21) vers la première zone (11) suivant le premier chemin optique et le deuxième faisceau incident (22) vers la deuxième zone (12) suivant le deuxième chemin optique, de manière à former un premier faisceau réfléchi (31) par réflexion sur la première zone (11) et, respectivement, un deuxième faisceau réfléchi (32) par réflexion sur la deuxième zone (12),

- un dispositif de recombinaison optique (3, 13, 23) adapté pour recombiner le premier faisceau réfléchi (31) et le deuxième faisceau réfléchi (32) et pour former un faisceau interférométrique (30) ;

- des moyens de détection (8, 81, 82, 83, 84) adaptés pour recevoir le faisceau interférométrique (30) et détecter un signal interférométrique (40) en fonction du temps d'exposition de la première zone (11) audit plasma ;

- des moyens de traitement adaptés pour traiter le signal interférométrique (40) de manière à déterminer la profondeur (d) du cratère d'érosion en fonction du temps d'exposition de la première zone (11) audit plasma.

2. Système de spectrométrie de décharge luminescente selon la revendication 1 dans lequel les moyens de détection (8, 81, 82, 83, 84) et les moyens de traitement sont adaptés pour traiter le signal interférométrique (40) et pour en extraire une mesure de l'amplitude (A) et de la phase (PHI) du signal interférométrique (40) en fonction du temps d'exposition de la première zone (11) audit plasma.

3. Système de spectrométrie de décharge luminescente selon la revendication 1 ou 2 dans lequel le premier faisceau incident (21) forme un angle d'incidence inférieur à dix degrés par rapport à la normale à la surface de la première zone (11) de l'échantillon, et de préférence non nul et environ égal à cinq degrés.

4. Système de spectrométrie de décharge luminescente selon l'une des revendications 1 à 3 dans lequel l'échantillon (10) forme la cathode de la lampe à décharge et dans lequel la deuxième ouverture (42) est munie d'une fenêtre optique (14).

5. Système de spectrométrie de décharge luminescente selon l'une des revendications 1 à 4 dans lequel le séparateur optique (3, 13, 23) comprend au moins un prisme séparateur de polarisation.

6. Système de spectrométrie de décharge luminescente selon la revendication 5 dans lequel le séparateur optique (3, 13, 23) comprend un prisme de Wollaston (13) et le dispositif de recombinaison optique (3, 13, 23) comprend un autre prisme de Wollaston (23), et dans lequel les moyens optiques (4, 14, 24) adaptés pour diriger, respectivement, le premier faisceau incident (21) vers la première zone (11) et le deuxième faisceau incident (22) vers la deuxième zone (12) comprennent un système optique à lentille (4), lesdits prismes de Wollaston (13, 23) étant disposés dans le plan focal du système optique à lentille (4).

7. Système de spectrométrie de décharge luminescente selon l'une des revendications 1 à 5 dans lequel le séparateur optique (3) et le dispositif de recombinaison optique (3) sont confondus.

8. Système de spectrométrie de décharge luminescente selon l'une des revendications 1 à 7 dans lequel le spectromètre comprend un spectromètre de masse couplé à la lampe à décharge via une ouverture, le spectromètre de masse étant adapté pour mesurer au moins un signal représentatif d'espèces ionisées du plasma de décharge luminescente (19) par spectrométrie de masse.

9. Système de spectrométrie de décharge luminescente selon l'une des revendications 1 à 8 dans lequel le spectromètre comprend un spectromètre optique (70) couplé à la lampe à décharge via une fenêtre optique ou via un système optique à lentille (4), le spectromètre optique (70) étant adapté pour mesurer au moins un signal d'émission optique représentatif d'espèces excitées du plasma de décharge luminescente (19), de préférence dans une direction normale à la surface de la première zone (11) de l'échantillon (10).

**10.** Système de spectrométrie de décharge luminescente selon l'une des revendications 1 à 9 dans lequel le système de spectrométrie par décharge luminescente comporte un spectromètre optique (70) adapté pour mesurer au moins un signal d'émission optique (71) représentatif d'espèces excitées du plasma (19) de décharge luminescente, et dans lequel la source lumineuse (1) est adaptée pour émettre un faisceau lumineux (2) à une longueur d'onde sélectionnée en dehors d'une gamme de longueur d'onde de raies atomiques d'émission optique du plasma (19) de décharge luminescente.

**11.** Système de spectrométrie de décharge luminescente selon l'une des revendications 1 à 10 dans lequel les moyens de détection (8, 81, 82, 83, 84) comprennent un polarimètre adapté pour mesurer au moins une composante polarisée (35, 36, 37, 38) du faisceau interférométrique (30).

**12.** Système de spectrométrie de décharge luminescente selon la revendication 11 dans lequel ledit polarimètre comprend d'autres moyens de séparation optique (51, 52, 53, 54, 55) disposés de manière à séparer le faisceau interférométrique en une pluralité de composantes polarisées et une pluralité de détecteurs (81, 82, 83, 84) adaptés pour détecter chacun respectivement une composante polarisée (35, 36, 37, 38) de la pluralité de composantes polarisées du signal interférométrique (40).

**13.** Procédé de spectrométrie de décharge luminescente et de mesure *in situ* de la profondeur de gravure d'un échantillon comprenant les étapes suivantes :

- mise en place d'un échantillon (10) solide dans une lampe à décharge luminescente (60) comportant une anode (15) cylindrique ayant une première ouverture axiale (41) et une deuxième ouverture (42) décalée par rapport à l'axe de l'anode (15), l'échantillon (10) ayant, sur une même face, une première zone (11) exposée à un plasma de gravure (19) et une deuxième zone (12) protégée vis-à-vis du plasma de gravure (19) ;
- détection et analyse par spectrométrie d'émission optique et/ou par spectrométrie de masse d'au moins un signal représentatif d'espèces excitées et/ou ionisées (71) du plasma de décharge luminescente (19), en fonction du temps d'exposition de la première zone (11) audit plasma ;
- émission d'un faisceau lumineux (2) ;
- séparation spatiale ou angulaire du faisceau lumineux (2) en un premier faisceau incident (21) et un deuxième faisceau incident (22) ;
- orientation, respectivement, du premier faisceau incident (21) vers la première zone (11) suivant un premier chemin optique passant par la première ouverture axiale (41) de l'anode (15) et du deuxième faisceau incident (22) vers la deuxième zone (12) suivant un deuxième chemin optique, de manière à former un premier faisceau réfléchi (31) par réflexion sur la première zone, le premier faisceau réfléchi (31) passant par la première ouverture axiale (41) de l'anode (15) et, respectivement, un deuxième faisceau réfléchi (32) par réflexion sur la deuxième zone (12), le deuxième faisceau réfléchi (32) passant par la deuxième ouverture (42),
- recombinaison optique du premier faisceau réfléchi (31) et du deuxième faisceau réfléchi (32) et pour former un faisceau interférométrique (30) ;
- détection du faisceau interférométrique (30, 35, 36, 37, 38) pour former au moins un signal interférométrique (40) en fonction du temps d'exposition de la première zone (11) audit plasma ;
- traitement du au moins un signal interférométrique (40) pour en extraire une mesure de profondeur du cratère d'érosion en fonction du temps d'exposition de la première zone (11) audit plasma.

**14.** Procédé de spectrométrie de décharge luminescente et de mesure *in situ* de la profondeur de gravure d'un échantillon selon la revendication 13 comportant en outre les étapes suivantes :

- traitement du signal interférométrique (40) pour en extraire une mesure de la phase (PHI) du signal interférométrique (40) en fonction du temps d'exposition de la première zone (11) audit plasma (19) ;
- détermination à chaque instant *t* d'une vitesse instantanée de gravure $V_e$ de la première zone (11) de l'échantillon (10), par application de la formule suivante :

$$V_e = \frac{LAMBDA}{4 \times \pi} \times \frac{dPHI}{dt}$$

où LAMBDA représente la longueur d'onde de la source lumineuse (1) et dPHI/dt la dérivée par rapport au temps de la phase (PHI) du signal interférométrique (40) mesuré.

**15.** Procédé de spectrométrie de décharge luminescente et de mesure *in situ* de la profondeur de gravure d'un échantillon selon la revendication 13 ou 14 dans lequel le plasma de gravure (19) fonctionne en mode impulsionnel, par alternance d'une phase où le plasma est allumé et d'une autre phase où le plasma est éteint, et comprenant les étapes suivantes :

- la détection du au moins un signal interférométrique (40) est déclenchée pendant les phases où le plasma est allumé et/ou respectivement pendant les phases où le plasma est éteint, de manière à différencier un signal interférométrique associé aux phases où le plasma est allumé d'un autre signal interférométrique associé aux phases où le plasma est éteint,
- traitement du signal interférométrique associé aux phases où le plasma est allumé et/ou respectivement de l'autre signal interférométrique associé aux phases où le plasma est éteint de manière à corriger la mesure de profondeur du cratère d'érosion des dérives induites pendant les phases où le plasma est allumé et/ou respectivement pendant les phases où le plasma est éteint.

**Patentansprüche**

**1.** System zur Glimmentladungsspektroskopie und zur In-Situ-Messung der Ätztiefe einer Probe, mit:

- einer Glimmentladungslampe (60), die dazu ausgelegt ist, eine feste Probe (10) aufzunehmen und ein Ätzplasma (19) durch Glimmentladung zu schaffen, wobei die Probe (10) auf einer selben Seite eine dem Ätzplasma ausgesetzte erste Zone (11) und eine vor dem Ätzplasma geschützte zweite Zone (12) aufweist, wobei die Glimmentladungslampe (60) dazu ausgelegt ist, einen ersten optischen Weg zur ersten Zone (11) und einen zweiten optischen Weg zur zweiten Zone (12) der Probe zu liefern, wobei die Entladungslampe eine zylindrische Anode (15) aufweist, die eine erste axiale Öffnung (41) hat, die für das Passieren eines ersten einfallenden Strahls (21) ausgelegt ist, und bei der die Anode (15) eine gegenüber der Achse der Anode (15) versetzte zweite Öffnung (42) aufweist, wobei die zweite Öffnung (42) für das Passieren eines zweiten einfallenden Strahls (22) ausgelegt ist,
- einem mit der Glimmentladungslampe (60) gekoppelten Spektrometer, wobei das Spektrometer dazu ausgelegt ist, in Abhängigkeit von der Dauer, während der die erste Zone (11) dem Plasma ausgesetzt ist, wenigstens ein für das Plasma der Glimmentladung (19) repräsentatives Signal durch optische Ausstrahlungsspektroskopie und/oder durch Massenspektroskopie zu messen,
- einem System (100) zur In-Situ-Messung der Tiefe des durch Gravur der ersten Zone (11) der Probe (10) in Abhängigkeit von der Dauer des dem Plasma Ausgesetztseins erzeugten Erosionskraters,

wobei das System (100) zur Messung der Tiefe des Erosionskraters

- eine zum Aussenden eines Lichtstrahls (2) ausgelegte Lichtquelle (1),
- einen optischen Teiler (3, 13, 23) zum räumlichen oder winkelmäßigen Teilen des Lichtstrahls (2) in den ersten einfallenden Strahl (21) und den zweiten einfallenden Strahl (22),
- optische Mittel (4, 14, 24), die dazu ausgelegt sind, den ersten einfallenden Strahl (21) entlang des ersten optischen Weges auf die erste Zone (11) zu richten und den zweiten einfallenden Strahl (22) entlang des optischen Wegs auf die zweite Zone zu richten, um einen ersten reflektierten Strahl (31) durch Reflexion auf der ersten Zone (11) und einen zweiten reflektierten Strahl (32) durch Reflexion auf der zweiten Zone (12) zu bilden,
- eine optische Rekombinationsvorrichtung (3, 13, 23) zum Rekombinieren des ersten reflektierten Strahls (31) mit dem zweiten reflektierten Strahl (32) und zum Bilden eines interferometrischen Strahls (30),
- Erfassungsmittel 8, 81, 82, 83, 84), die dazu ausgelegt sind, den interferometrischen Strahl (30) zu empfangen und ein interferometrisches Signal (40) in Abhängigkeit von der Dauer des dem Plasma Ausgesetztseins zu erfassen,
- Verarbeitungsmittel, die dazu ausgelegt sind, das interferometrische Signal (40) so zu verarbeiten, daß die Tiefe (d) des Erosionskraters in Abhängigkeit von der Dauer des dem Plasma Ausgesetztseins der ersten Zone (11) bestimmt wird,

aufweist.

**2.** System zur Glimmentladungsspektroskopie gemäß Anspruch 1, bei dem die Erfassungsmittel (8, 81, 82, 83, 84) und die Verarbeitungsmittel zum Verarbeiten des interferometrischen Signals (40) und zum Extrahieren eines Amplituden- (A) und eines Phasenmaßes (PHI) des interferometrischen Signals (40) in Abhängigkeit von der Dauer des dem Plasma Ausgesetztseins ausgelegt sind.

3.  System zur Glimmentladungsspektroskopie gemäß Anspruch 1 oder 2, bei dem der erste einfallende Strahl (21) einen Einfallswinkel von weniger als zehn Grad gegenüber der Normalen auf der Oberfläche der ersten Zone (11) der Probe bildet, und vorzugsweise nicht Null und ungefähr gleich fünf Grad.

4.  System zur Glimmentladungsspektroskopie gemäß einem der Ansprüche 1 bis 3, bei dem die Probe (10) die Kathode der Entladungslampe bildet und bei dem die zweite Öffnung (42) mit einem optischen Fenster (14) versehen ist.

5.  System zur Glimmentladungsspektroskopie gemäß einem der Ansprüche 1 bis 4, bei dem der optische Teiler (3, 13, 23) wenigstens ein Polarisationsteilerprisma aufweist.

6.  System zur Glimmentladungsspektroskopie gemäß Anspruch 5, bei dem der optische Teiler (3, 13, 23) ein Wollaston-Prisma (13) aufweist und die optische Rekombinationsvorrichtung (3, 13, 23) ein weiteres Wollaston-Prisma (23) aufweist, und bei dem die optischen Mittel (4, 14, 24), die dazu ausgelegt sind, den ersten einfallenden Strahl (21) auf die erste Zone (11) und den zweiten einfallenden Strahl (22) auf die zweite Zone zu richten, ein optisches System mit Linsen (4) aufweisen, wobei die Wollaston-Prismen (13, 23) in der Brennebene des optischen Systems mit Linsen (4) angeordnet sind.

7.  System zur Glimmentladungsspektroskopie gemäß einem der Ansprüche 1 bis 5, bei dem der optische Teiler (3) und die optische Rekombinationsvorrichtung (3) zusammengelegt sind.

8.  System zur Glimmentladungsspektroskopie gemäß einem der Ansprüche 1 bis 7, bei dem das Spektrometer ein Massenspektrometer aufweist, das über eine Öffnung mit der Entladungslampe verbunden ist, wobei das Massenspektrometer dazu ausgelegt ist, wenigstens ein für ionisierte Teilchen des Glimmentladungsplasmas (19) repräsentatives Signal durch Massenspektroskopie zu messen.

9.  System zur Glimmentladungsspektroskopie gemäß einem der Ansprüche 1 bis 8, bei dem das Spektrometer ein über ein optisches Fenster oder über ein optisches System mit Linse (4) mit der Entladungslampe verbundenes optisches Spektrometer (70) aufweist, wobei das optische Spektrometer (70) dazu ausgelegt ist, wenigstens ein für angeregte Teilchen des Glimmentladungsplasmas (19) repräsentatives Signal optischer Ausstrahlung zu messen, vorzugsweise in einer zur Oberfläche der ersten Zone (11) der Probe (10) senkrechten Richtung.

10. System zur Glimmentladungsspektroskopie gemäß einem der Ansprüche 1 bis 9, bei dem das System zur Glimmentladungsspektroskopie ein optisches Spektrometer (70) aufweist, das dazu ausgelegt ist, wenigstens ein für angeregte Teilchen des Glimmentladungsplasmas (19) repräsentatives Signal optischer Ausstrahlung (71) zu messen, und bei dem die Lichtquelle (1) dazu ausgelegt ist, einen Lichtstrahl (2) mit einer außerhalb eines Wellenlängenbereichs von Atomlinien optischer Ausstrahlung des Gasentladungsplasmas (19) ausgewählten Wellenlänge auszusenden.

11. System zur Glimmentladungsspektroskopie gemäß einem der Ansprüche 1 bis 10, bei dem die Erfassungsmittel (8, 81, 82, 83, 84) ein Polarimeter aufweisen, das dazu ausgelegt ist, wenigstens eine polarisierte Komponente (35, 36, 37, 38) des interferometrischen Strahls (30) zu messen.

12. System zur Glimmentladungsspektroskopie gemäß Anspruch 11, bei dem das Polarimeter weitere optische Teilungsmittel (51, 52, 53, 54, 55), die so angeordnet sind, daß der interferometrische Strahl in eine Anzahl polarisierter Komponenten aufgeteilt wird, und eine Anzahl Sensoren (8, 82, 83, 84), die dazu ausgelegt sind, jeweils eine polarisierte Komponente (35, 36, 37, 38) der Anzahl polarisierter Komponenten des interferometrischen Signals (40) zu erfassen, aufweist.

13. Verfahren zur Glimmentladungsspektroskopie und zur In-Situ-Messung der Ätztiefe einer Probe, das die folgenden Schritte aufweist:

    - Einsetzen einer festen Probe (10) in eine Glimmentladungslampe (60) die eine zylindrische Anode (15) aufweist, die eine erste axiale Öffnung (41) und eine gegenüber der Achse der Anode (15) versetzte zweite Öffnung (42) aufweist, wobei die Probe (10) auf einer selben Seite eine einem Ätzplasma (19) ausgesetzte erste Zone (11) und eine vor dem Ätzplasma (19) geschützte zweite Zone (12) aufweist,

- Erfassen und Analysieren durch optische Ausstrahlungsspektroskopie und/oder durch Massenspektroskopie eines für angeregte und/oder ionisierte Teilchen (71) des Glimmentladungsplasmas (19) repräsentatives Signal in Abhängigkeit von der Dauer des dem Plasma Ausgesetztseins der ersten Zone (11),
- Aussenden eines Lichtstrahls (2),
- räumliches und winkelmäßiges Teilen des Lichtstrahls (2) in einen ersten einfallenden Strahl (21) und einen zweiten einfallenden Lichtstrahl (22),
- Richten des ersten einfallenden Strahls (21) entlang des durch die erste axiale Öffnung (41) der Anode (15) führenden ersten optischen Weges auf die erste Zone (11) und Richten des zweiten einfallenden Strahls (22) entlang des optischen Wegs auf die zweite Zone (12), um einen ersten reflektierten Strahl (31) durch Reflexion auf der ersten Zone zu bilden, wobei der erste reflektierte Strahl (31) durch die erste axiale Öffnung (41) der Anode (15) geht, beziehungsweise einen zweiten reflektierten Strahl (32) durch Reflexion auf der zweiten Zone (12) zu bilden, wobei der zweite reflektierte Strahl (32) durch die zweite Öffnung (42) geht,
- Optisches Rekombinieren des ersten reflektierten Lichtstrahls (31) und des zweiten reflektierten Lichtstrahls (32), um einen interferometrischen Strahl (30) zu bilden,
- Erfassen des interferometrischen Strahls (30, 35, 36, 37, 38), um wenigstens ein interferometrisches Signal (40) in Abhängigkeit von der Dauer des dem Plasma Ausgesetztseins der ersten Zone (11) zu bilden,
- Verarbeiten des wenigstens einen interferometrischen Signals (40), um daraus ein Maß die Tiefe des Erosionskraters in Abhängigkeit von der Dauer des dem Plasma Ausgesetztseins der ersten Zone (11) abzuleiten.

14. Verfahren zur Glimmentladungsspektroskopie und zur In-Situ-Messung der Ätztiefe einer Probe gemäß Anspruch 13, das außerdem die folgenden Schritte aufweist:

- Verarbeiten des interferometrischen Signals (40), um daraus ein Maß für die Phase (PHI) des interferometrischen Signals (40) in Abhängigkeit von der Dauer des dem Plasma Ausgesetztseins der ersten Zone (11) abzuleiten,
- zu jedem Zeitpunkt t Bestimmen einer momentanen Ätzgeschwindigkeit $V_e$ der ersten Zone (11) der Probe (10) unter Anwendung der folgenden Formel:

$$V_e = \frac{LAMBDA}{4 \times \pi} \times \frac{dPHI}{dt}$$

wobei LAMBA die Wellenlänge der Lichtquelle (1) und PHI/dt die Ableitung nach der Zeit der Phase (PHI) des gemessenen interferometrischen Signals (40) darstellt.

15. Verfahren zur Glimmentladungsspektroskopie und zur In-Situ-Messung der Ätztiefe einer Probe gemäß Anspruch 13 oder 14, bei dem das Ätzplasma (19) im Impulsmodus funktioniert, und zwar alternierend mit einer Phase, bei der das Plasma aktiviert ist, und einer anderen Phase, bei der das Plasma deaktiviert ist, und das die folgenden Schritte aufweist:

- das Erfassen des wenigstens einen interferometrischen Signals (40) wird während der Phasen ausgelöst, bei denen das Plasma aktiviert ist und/oder während der Phasen, bei denen das Plasma deaktiviert ist, um ein den Phasen, bei denen das Plasma aktiviert ist, zugeordnetes interferometrisches Signal von einem anderen interferometrischen Signal, das den Phasen zugeordnet ist, bei denen das Plasma deaktiviert ist, zu unterscheiden,
- Verarbeiten des den Phasen, bei denen das Plasma aktiviert ist, zugeordneten interferometrischen Signals und/oder des anderen, den Phasen, bei denen das Plasma deaktiviert ist, zugeordneten Signals, um das Maß der Tiefe des Ätzkraters um die Abweichungen zu korrigieren, die während der Phasen, bei denen das Plasma aktiviert ist und/oder während der Phasen, bei denen das Plasma deaktiviert ist, eingebracht werden.

## Claims

1. System of glow discharge spectrometry and *in situ* measurement of the etching depth of a sample, comprising:

- a glow discharge lamp (60) adapted to receive a solid sample (10) and to form a glow discharge etching plasma (19), the sample (10) having, on a same face, a first zone (11) exposed to the etching plasma and a second zone (12) protected from the etching plasma, the glow discharge lamp (60) being adapted to provide a first optical path towards the first zone (11) and a second optical path towards the second zone (12) of the sample, the discharge lamp includes a cylindrical anode (15) having a first axial opening (41) adapted for the passage of a first incident beam (21) and wherein the anode (15) includes a second opening (42), offset with respect to the axis of the anode (15), the second opening (42) being adapted for the passage of a second incident beam (22);

- a spectrometer coupled to the glow discharge lamp (60), the spectrometer being adapted to measure, as a function the time of exposure of the first zone (11) to said plasma, at least one signal representative of the glow discharge plasma (19) by optical emission spectrometry and/or by mass spectrometry;

- a system (100) of *in situ* measurement of the depth of the erosion crater generated by etching of the first zone (11) of the sample (10) as a function of the time of exposure to said plasma;

the system (100) of measurement of the erosion crater depth including:

- a light source (1) adapted to emit a light beam (2);
- an optical splitter (3, 13, 23) adapted to spatially or angularly split the light beam (2) into the first incident beam (21) and the second incident beam (22);
- optical means (4, 14, 24) adapted to direct, respectively, the first incident beam (21) towards the first zone (11) along the first optical path and the second incident beam (22) towards the second zone (12) along the second optical path, so as to form a first reflected beam (31) by reflection on the first zone (11) and, respectively, a second reflected beam (32) by reflection on the second zone (12);
- an optical recombination device (3, 13, 23) adapted to recombine the first reflected beam (31) and the second reflected beam (32) and to form an interferometric beam (30);
- detection means (8, 81, 82, 83, 84) adapted to receive the interferometric beam (30) and to detect an interferometric signal (40) as a function of the time of exposure of the first zone (11) to said plasma;
- processing means adapted to process the interferometric signal (40) so as to determine the depth (d) of the erosion carter as a function of the time of exposure of the first zone (11) to said plasma.

2. The glow discharge spectrometry system according to claim 1, wherein the detection means (8, 81, 82, 83, 84) and the processing means are adapted to process the interferometric signal (40) and to extract therefrom a measurement of the amplitude (A) and of the phrase (PHI) of the interferometric signal (40) as a function of the time of exposure of the first zone (11) to said plasma.

3. The glow discharge spectrometry system according to claim 1 or 2, wherein the first incident beam (21) forms an angle of incidence lower than ten degrees with respect to the normal to the surface of the first zone (11) of the sample, and preferably non zero and approximately equal to five degrees.

4. The glow discharge spectrometry system according to one of claims 1 to 3, wherein the sample (10) forms the cathode of the discharge lamp and wherein the second opening (42) is provided with an optical window (14).

5. The glow discharge spectrometry system according to one of claims 1 to 4, wherein the optical separator (3, 13, 23) comprises at least one polarization-splitting prism.

6. The glow discharge spectrometry system according to claim 5, wherein the optical separator (3, 13, 23) comprises a Wollaston prism (13) and the optical recombination device (3, 13, 23) comprises another Wollaston prism (23), and wherein the optical means (4, 14, 24) adapted to direct, respectively, the first incident beam (21) towards the first zone (11) and the second incident beam (22) towards the second zone (12) comprise a lens optical system (4), said Wollaston prisms (13, 23) being arranged in the focal plane of the lens optical system (4).

7. The glow discharge spectrometry system according to one of claims 1 to 5, wherein the optical separator (3) and the optical recombination device (3) are merged together.

8. The glow discharge spectrometry system according to one of claims 1 to 7, wherein the spectrometer comprises a mass spectrometer coupled to the discharge lamp via an opening, the mass spectrometer being adapted to measure at least one signal representative of ionised species of the glow discharge plasma (19) by mass spectrometry.

9. The glow discharge spectrometry system according to one of claims 1 to 8, wherein the spectrometer comprises an optical spectrometer (70) coupled to the discharge lamp via an optical window or via a lens optical system (4), the optical spectrometer (70) being adapted to measure at least one optical emission signal representative of excited species of the glow discharge plasma (19), preferably in a direction normal to the surface of the first zone (11) of the sample (10).

10. The glow discharge spectrometry system according to one of claims 1 to 9, wherein the glow discharge spectrometry system includes an optical spectrometer (70) adapted to measure at least one optical emission signal (71) representative of excited species of the glow discharge plasma (19), and wherein the light source (1) is adapted to emit a light beam (2) at a wavelength selected outside of a range of wavelengths of atomic rays of optical emission of the glow discharge plasma (19).

11. The glow discharge spectrometry system according to one of claims 1 to 10, wherein the detection means (8, 81, 82, 83, 84) comprise a polarimeter adapted to measure at least one polarized component (35, 36, 37, 38) of the interferometric beam (30).

12. The glow discharge spectrometry system according to claim 11, wherein said polarimeter comprises other optical separation means (51, 52, 53, 54, 55) arranged so as to split the interferometric beam into a plurality of polarized components and a plurality of detectors (81, 82, 83, 84) adapted to each detect respectively a polarized component (35, 36, 37, 38) of the plurality of polarized components of the interferometric signal (40).

13. A method of glow discharge spectrometry and *in situ* measurement of the etching depth of a sample, comprising the following steps:

- placing a solid sample (10) into a glow discharge lamp (60) comprising a cylindrical anode (15) having a first axial opening (41) and a second opening (42), offset with respect to the axis of the anode (15), the sample (10) having, on a same face, a first zone (11) exposed to an etching plasma (19) and a second zone (12) protected from the etching plasma (19);
- detection and analysis by optical emission spectrometry and/or by mass spectrometry of at least one signal representative of excited and/or ionized species (71) of the glow discharge plasma (19), as a function of the time of exposure of the first zone (11) to said plasma;
- emission of a light beam (2);
- spatial or angular split of the light beam (2) into a first incident beam (21) and a second incident beam (22);

- orientation, respectively, of the first incident beam (21) towards the first zone (11) along a first optical path passing through the first axial opening (41) and of the second incident beam (22) towards the second zone (12) along a second optical path, so as to form a first reflected beam (31) by reflection on the first zone, the first reflected beam (31) passing through the first axial opening (41) of the anode and, respectively, a second reflected beam (32) by reflection on the second zone (12), the second reflected beam (32) passing through the second opening (42);

- optical recombination of the first reflected beam (31) and of the second reflected beam (32) and to form an interferometric beam (30);
- detection of the interferometric beam (30, 35, 36, 37, 38) to form at least one interferometric signal (40) as a function of the time of exposure of the first zone (11) to said plasma; and
- processing of the at least one interferometric signal (40) to extract therefrom a measurement of the erosion crater depth as a function of the time of exposure of the first zone (11) to said plasma.

14. The method of glow discharge spectrometry and *in situ* measurement of the etching depth of a sample according to claim 13, further including the following steps:

- processing of the interferometric signal (40) to extract therefrom a measurement of the phase (PHI) of the interferometric signal (40) as a function of the time of exposure of the first zone (11) to said plasma (19);
- determination, at each instant t, of an instantaneous etching rate $V_e$ of the first zone (11) of the sample (10), by application of the following formula:

$$V_e = \frac{LAMBDA}{4 \times \pi} \times \frac{dPHI}{dt}$$

where LAMBDA represents the wavelength of the light source (1) and dPHI/dt the derivative with respect to time of the phase (PHI) of the interferometric signal measured (40).

**15.** The method of glow discharge spectrometry and *in situ* measurement of the etching depth of a sample according to claim 13 or 14, wherein the etching plasma (19) operates in a pulsed mode, by alternation of a phase in which the plasma is switched-on and another phase in which the plasma is switched-off, and comprising the following steps:

- the detection of the at least one interferometric signal (40) is triggered during the phases in which the plasma is switched-on and/or, respectively, during the phases in which the plasma is switched-off, so as to differentiate an interferometric signal associated with the phases in which the plasma is switched-on from another interferometric signal associated with the phases in which the plasma is switched-off,
- processing of the interferometric signal associated with the phases in which the plasma is switched-on and/or, respectively, of the other interferometric signal associated with the phases in which the plasma is switched-off so as to correct the measurement of the erosion crater depth from the drifts induced during the phases in which the plasma is switched-on and/or, respectively, during the phases in which the plasma is switched-off

# Fig.1

# Fig.2

Fig.3

# Fig.4

## RÉFÉRENCES CITÉES DANS LA DESCRIPTION

**Documents brevets cités dans la description**

- WO 2007113072 A1
- CN 102829732
- US 6784989 B
- FR 2843801
- FR 1250594

**Littérature non-brevet citée dans la description**

- **P. YEH.** Optical waves in layered média. Wiley, 1988